# EUROPEAN PATENT SPECIFICATION

(11) **EP 0 771 071 B1**
(45) Date of publication and mention of the grant of the patent: **16.08.2001**
(21) Application number: 96116954.7
(22) Date of filing: 22.10.1996
(51) Int. Cl.: H03H 11/04, H03H 17/02

(54) **Matched filter circuit**
Signalangepasste Filterschaltung
Circuit de filtrage apparié

(30) Priority: 23.10.1995 JP 29919795
(43) Date of publication of application: 02.05.1997
(73) Proprietor: Yozan Inc., Tokyo 155-0031 (JP); NTT MOBILE COMMUNICATIONS NETWORK INC., Minato-ku, Tokyo 105-8436 (JP)
(72) Inventor: Shou, Guoliang c/o Yozan Inc., Setagaya-ku, Tokyo 155, (JP); Zhou, Changming c/o Yozan Inc., Setagaya-ku, Tokyo 155, (JP); Yamamoto, Makoto c/o Yozan Inc., Setagaya-ku, Tokyo 155, (JP); Takatori, Sunao c/o Yozan Inc., Setagaya-ku, Tokyo 155, (JP); Adachi, Fumiyuki, Yokohama-shi, Kanagawa 236 (JP); Sawahashi, Mamoru, Yokohama-shi, Kanagawa 236, (JP)
(74) Representative: Grünecker, Kinkeldey, Stockmair & Schwanhäusser Anwaltssozietät

(56) References cited:
- US-A- 4 507 746
- US-A- 5 408 192
- ELECTRONICS AND COMMUNICATION ENGINEERING JOURNAL, vol. 5, no. 2, 1 April 1993, pages 59-64, XP000363818 POVEY G J R ET AL: "SIMPLIFIED MATCHED FILTER RECEIVER DESIGNS FOR SPREAD SPECTRUM COMMUNICATIONS APPLICATIONS"
- Data sheet for Harris Semiconductors HSP3824 Matched filter Correlator with Sample Clock Timing. (undated, cited as background infrmation).

## Description

The present invention relates to a matched filter circuit for a spread spectrum communication system of a mobile communication and a wireless LAN, especially to a matched filter which is capable of high speed processing and double-sampling by a LSI of small size with reduced power consumption.

A matched filter circuit is a filter for judging the identification of two signals. In the spread spectrum communication, unique sprcading code sequences are allocated to users. Each user finds a signal transmitted for the user by a matched filter to which one spreading code sequence is applied. The matched filter outputs correlation peak when the signal is the user's for a aquisition and holding.

Assuming a spreading code to be PN(i), a chip time to be Tc, a spreading ratio to be M, a time to be (t), an input signal on a time t to be S(t) and a correlational output signal on a time t to be R(t), the formula (1) can be obtained. 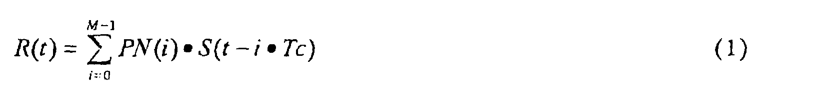 Here, PN(i) is a 1 bit data sequence.

As double or higher order of sampling is necessary for the acquisition, the calculation of the formula (1) is performed in a plurality of systems at the same time using a plurality of matched filter circuits and the calculation results are added. In order to realize such a matched filter, a digital circuit or a SAW (Surface Acoustic Wave) device was conventionally used. However, using a digital circuit, the electric power consumption was large because the size of a circuit was large, therefore, it was not appropriate to a mobile communication. Using a SAW element, it was not easy to realize a whole circuit by an element and the S/N ratio was low.

Since the spreading code is a 1 bit string, the inventors have proposed a matched filter in Japanese patent application No. 7-212438, capable of high-speed processing by a small size and low power consumption LSI by i) sampling and holding input signals as analog signals of time series, ii) branching out them into the signal groups "1" and "-1" by a multiplexer, and iii) adding the signals in each groups in parallel by a capacitive coupling.

However in the above mentioned patent application there is no clear suggestion with respect to a doublesampling.

US-A 5 408 192 discloses a monolithic broadband phase shifting circuit for analog data signals according to the preamble portion of claim 1.

The object of the present invention is to provide a matched filter circuit for performing double-sampling.

This object is solved by a matched filter having the features of claim 1.

In a matched filter circuit according to the present invention, a sampling and holding circuit is classified into two groups, a control circuit successively closes one of the switches in a first group every chip time, at the same time, successively closes one of the switches in a second group at a shifted timing by 1/2 chip time from the timing of the first group.

Fig. 1 shows a block diagram of an embodiment of the matched filter circuit according to the present invention.

Fig. 2 shows a block diagram of a calculation portion of each matched filter circuit.

Fig. 3 shows a sampling and holding circuit in Fig. 2.

Fig. 4 shows a switch in Fig. 3.

Fig. 5 shows a multiplexer in Fig. 3.

Fig. 6 shows the first adder in Fig. 2.

Fig. 7 shows the fifth adder in Fig. 2.

Fig. 8 shows the sixth adder in Fig. 2.

Fig. 9 shows a circuit for generating a reference voltage.

Fig. 10 shows an accumulation circuit in Fig. 1.

Fig. 11 shows a circuit of a second embodiment.

Fig. 12 illustrates the relationship of the timing of an input signal and clock signals.

Hereinafter a first embodiment of the matched filter circuit according to the present invention is described with reference to the attached drawings.

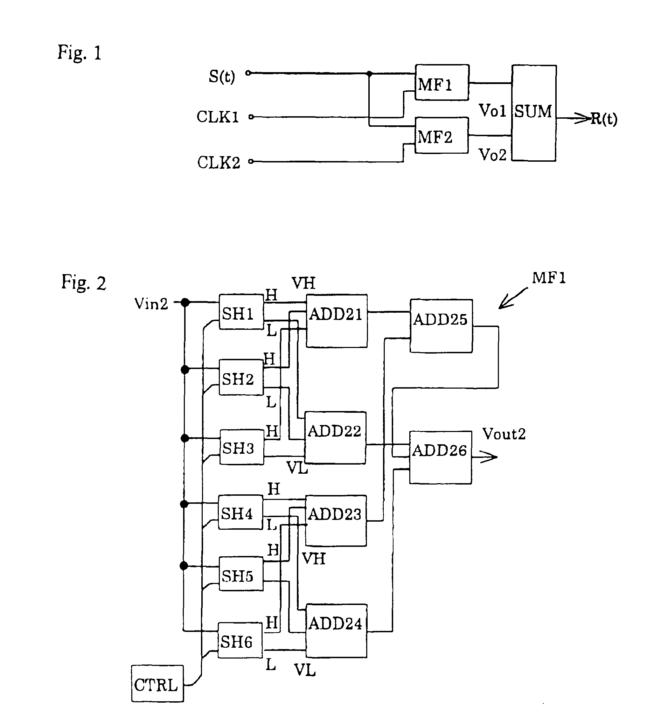

In Fig. 1, a receiver system of a spread spectrum communication includes a plurality of matched filter circuits MF1 and MF2 having outputs Vo1 and Vo2 which are added by an adder SUM. A main clock CLK1 and a sub-clock CLK2 which are shifted by a half of a chip time Tc/2 from each other are input to the MF1 and MF2. The MF1 and MF2 perform correlational calculations adopting the clocks as sampling clocks, that is, double-sampling is performed.

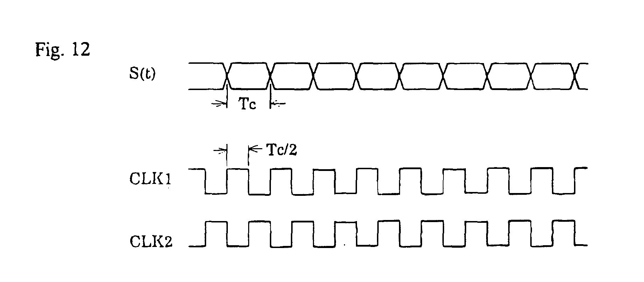

Fig 12 shows timings of S(t), CLK1 and CLK2. One cycle of S(t) coincides with the chip time. CLK1 and CLK2 are signals of the same cycle as S(t). As shown in Fig.12, CLK1 and CLK2 are theoretically synchronous with S(t), however, there are many cases that a phase difference occurs on S(t). The phases of CLK1 and CLK2 are shifted by Tc/2 and they are inverted by two clocks shifted by Tc/2 (double-sampling) so that a correlational peak can be surely detected.

In Fig. 2, in the calculating portion MF1 of the matched filter circuit, an input voltage Vin2 is parallelly connected to a plurality of sampling and holding circuits SH1, SH2, SH3, SH4, SH5 and SH6, and two types of outputs of H (high) and L (low) arc generated from each sampling and holding circuit. A control circuit CTRL is connected to the sampling and holding circuit so as to control S(t) to be input to one of the sampling and holding circuits, successively.

The sampling and holding circuit introduces the input voltage Vin2 to either H side or L side according to the control of the control circuit. A reference voltage Vr is connected by the control circuit to the other side. This route selection is performed according to each bit of spreading code (PN code) and a multiplication of input voltage by the code is accomplished only by this selection.

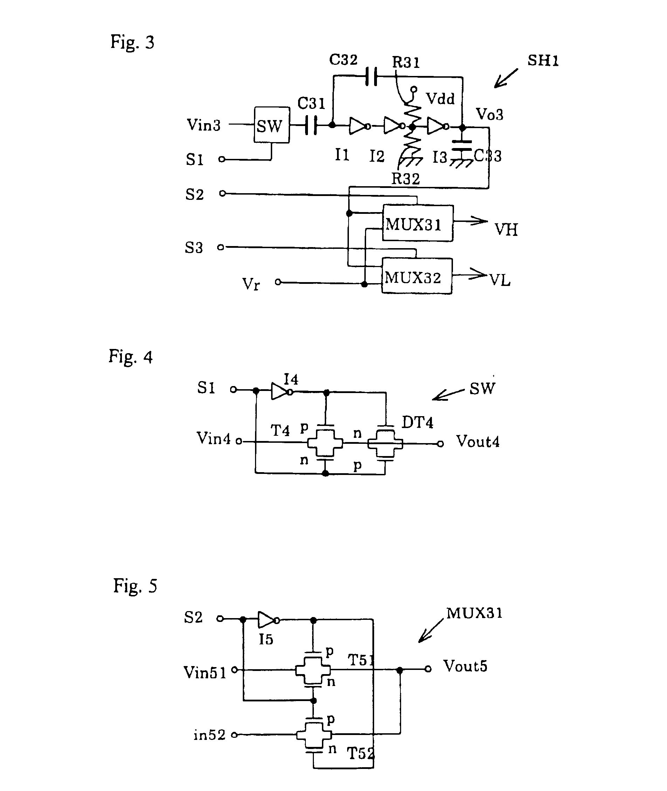

The sampling and holding circuit SH1 is structured as in Fig. 3, in which an input voltage Vin3 is connected to a switch SW. An output of switch SW is connected to capacitance C31, and three stages of serial MOS inverters I1, I2 and I3 arc connected to an output of capacitance C31. An output of MOS inverter 13 of the last stage is connected to an input of I1 through feedback capacitance C32. Consequently, an inversion of Vin is generated at the output of I3 with a good linearity. An output of 13 is input to two multiplexers MUX31 and MUX32. A common reference voltage Vr is connected to the multiplexers. When SW is closed, C31 is charged by an electric charge corresponding to Vin3, and the linearity of an output is guaranteed by a feed-back function of I1 to I3. When a switch SW is open after it, sampling and holding circuit SH1 holds S(t).

Switch SW and multiplexers MUX31, MUX32 are controlled by control signals S1, S2 and S3. After S1 is closed, SW is opened at the timing of sampling of the input voltage. S2 and S3 are inverted signals. When one of the multiplexers outputs Vin, the other outputs Vr.

MUX31 generates an outputs of H (high type) above and MUX32 generates an output of L (low type). H and L correspond to each bit of the spreading codes "1" and "-1". When the code "1" is to be multiplied to an input voltage, Vin3 is output from MUX31, and when the code "-1" is to be multiplied, Vin3 is output from MUX32.

The output from 13 of the last stage is connected to the ground through a grounded capacitance C33. The output of 12 of the second stage is connected to the supply voltage Vdd and the ground through a pair of balancing resistances R31 and R32. Unstable oscillations of an inverted amplifying circuit including feedback circuit is prevented by such a structure.

As shown in Fig. 4, the switch SW includes a transistor circuit T4 in which a source and a drain of a n-type MOS transistor are connected to a drain and a source of a p-type MOS transistor, respectively. Vin4 is connected to a terminal of a drain of the nMOS of the transistor circuit and a terminal of a source of nMOS is connected to an output terminal Vout4 through a dummy transistor DT4 similar to the nMOS. S1 is input to the gate of the nMOS transistor of the transistor circuit T4, and an inverted signal of S1 by an inverter I4 is input to the gate of pMOS transistor. When S1 is high level, T4 is conductive and when it is low level, T4 is cut off.

As shown in Fig. 5, in multiplexer MUX31, the terminal of the source of nMOS of transistor circuits T51 and T52 is connected to the common output terminal Vout5. An output Vo3 ("Vin51" in Fig. 5) of the MOS inverter 13 is connected to a terminal of a drain of the nMOS of T51, and the reference voltage Vr ("Vin52" in Fig. 5) is connected to a drain of T52. The signal S2 is input to a gate of the nMOS transistor of transistor circuit T51 and gate of the pMOS transistor of transistor circuit T52. The signal S2 inverted by inverter I5 is input to gates of the pMOS of T51 and nMOS of T52. When S2 is high level, T51 is conductive and T52 is cut off, and when low level, T52 is conductive and T51 is cut off. That is, MUX31 can alternatively output Vo3 or Vr in response to the control signal S2. Though it is not shown in the figure, multiplexer MUX32 is structured similar to MUX31 and Vo3 and Vr are connected inversely. Vr and Vo3 of Fig. 5 arc connected to T51 and T52, respectively, contrary to the construction of Fig. 5. Consequently, MUX32 outputs signals inversely to MUX31; that is, when MUX31 outputs Vo3, MUX32 outputs Vr and when MUX31 output Vr, MUX32 outputs Vo3.

Signal S2 corresponds to spreading code and outputs 1 × Vin2=Vin2 to ADD21 when S2=1. At this time, S3 is -1 and Vr corresponding 0 is output to ADD22. When S2=-1, Vr corresponding to 0 is output to ADD21. Here, S3=+1 and outputs 1 × Vin2=Vin2 to ADD22.

The S(t-i·Tc) in the formula (1) is an input voltage held in each sampling and holding circuit, and PN(i) is the signal S2(spreading code) to be input to each sampling and holding circuit. The order of the spreading codes is predetermined corresponding to the order of input signals. When a new signal is taken, the oldest signal is substituted by the newest signal. It causes change in relationship between each sampling and holding circuit SH1 to SH6 and PN(i), so PN(i) is shifted by the control circuit. When a code shift is not performed, code transfer through successive sampling and holding circuits and some errors may be generated due to data transfer. It will be understood that the code shift is effective to prevent the error during data transfer.

The accumulation in formula (1) is performed in the addition portions from ADD21 to ADD26, VH and VL of output voltages of each sampling and holding circuit are accumulated in ADD25 and ADD26, respectively. This accumulation is not performed directly. Sampling and holding circuits are divided into a plurality of groups, outputs VH and VL are once accumulated in ADD21 to ADD24 by each group. All of the outputs of ADD21 and ADD23 for accumulating VH are input to ADD25, and all of the outputs of ADD22 and ADD24 for accumulating VL are input to ADD26. Further, an output of ADD25 is also input to ADD26. In Fig. 2, six sampling and holding circuits are shown and divided into two groups with three circuits. Generally a spreading code includes from 100 to several hundreds or more bits. Sampling and holing circuits are set to be an appropriate number.

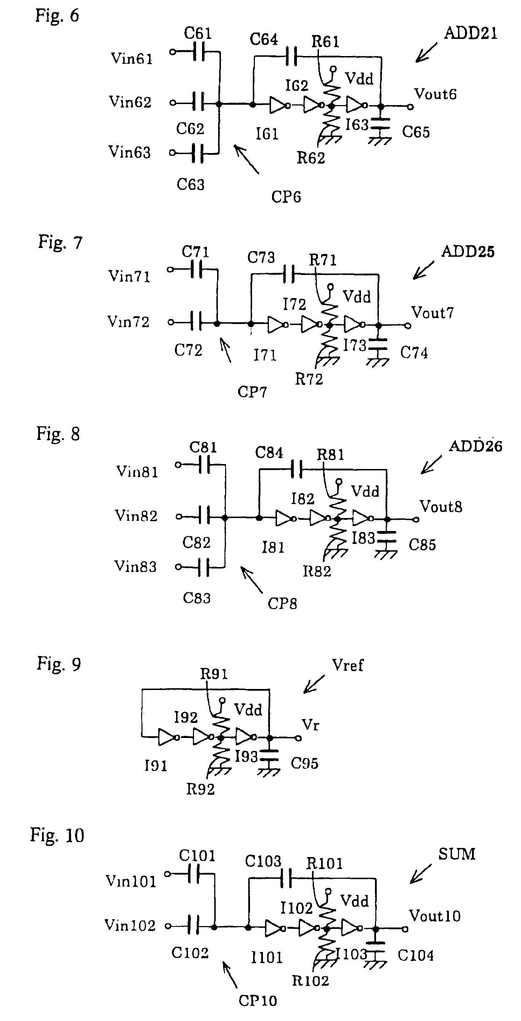

As shown in Fig. 6, the addition portion ADD21 includes a capacitive coupling CP6 constructed by capacitances C61, C62 and C63 of the number equal to the number of sampling and holding circuits in one group. An output of CP6 is connected to three serial stages of MOS inverters I61, I62 and I63. An output of MOS inverter 13 of the last stage is connected to an input of 161 through a feedback capacitance C64. An output of CP6 is generated at an output of 163 with a good linearity. Assuming input voltages of capacitances C61, C62 and C63 to be Vin61, Vin62 and Vin63, an output Vout6 of I63 can be expressed by the formula (2).$\text{Vout} \text{6 = -} \frac{\text{C} \text{61} \text{Vin} \text{61 +} \text{C} \text{62} \text{Vin} \text{62 +} \text{C} \text{63} \text{Vin} \text{63}}{\text{C} \text{64}}$ Here, Vin61 to Vin63 and Vout6 are voltages referencing the reference voltage Vr. Also it is defined that the capacity ratio of capacitances of C61, C62, C63 and C64 is 1:1:1:3. A normalized output of inverted addition value can be obtained as in formula (3).$\text{Vout} \text{6 = -} \frac{\text{Vin} \text{61 +} \text{Vin} \text{62 +} \text{Vin} \text{63}}{\text{3}}$ By the normalization, the maximum voltage is limited under the supply voltage.

An output of the last stage 163 is connected to the ground through a grounded capacitance C65. An output of the second stage inverter 162 is connected to the supply voltage Vdd and the ground through a pair of balancing resistances R61 and R62. Unstable oscillation of inverted amplifying circuit including feedback line is prevented by the structure.

As shown in Fig. 7, the addition portion ADD25 includes a capacitive coupling CP7 which includes capacitances C71 and C72 of corresponding number to the number of the addition portions ADD21 and ADD23. The output of CP7 is connected to three stages serial MOS inverters I71, I72 and I73. An output of MOS inverter I73 of the last stage is connected to an input of I71 through a feedback capacitance C73. An output of CP7 is generated at an output of I73 with a good linearity. Assuming input voltages of capacitances C71 and C72 to be Vin71 and Vin72, an output Vout 7 of I73 can be expressed by the formula (4).$\text{Vout} \text{7 = -} \frac{\text{C} \text{71} \text{Vin} \text{71 +} \text{C} \text{72} \text{Vin} \text{72}}{\text{C} \text{73}}$ Here, Vin71, Vin72 and Vout7 are voltages referencing the reference voltage Vr. Also, it is defined that the capacitance ratio is C71:C72:C73=1:1:2. Then, a normalized output of an inverted addition is obtained as in formula (5).$\text{Vout} \text{7 = -} \frac{\text{Vin} \text{71 +} \text{Vin} \text{72}}{\text{2}}$ By the normalization, the maximum voltage is limited under the supply voltage.

An output of the last stage inverter I73 is connected to the ground through grounded capacitance C74. An output of the second stage inverter I72 is connected to the supply voltage Vdd and the ground through a pair of balancing resistances R71 and R72. The unstable oscillation of inverted amplifying circuit including feedback line is prevented.

As shown in Fig. 8, addition portion ADD26 includes a capacitive coupling CP8 which includes capacitances C81, C82 and C83 of the number corresponding to the number of addition portion ADD22, ADD24 and ADD25 connected thereto, and an output of CP8 is connected to three stages serial MOS inverters I81, I82 and I83. An output of MOS inverter I83 of the last stage is connected to an input of I81 through a feedback capacitance C84. An output of CP8 is generated at an output of I83 with a good linearity. Assuming input voltages of capacitances C81, C82 and C83 (the voltage referencing Vr) to be Vin81, Vin82 and Vin83, an output Vout8 of I83 (the voltage referencing Vr) can be expressed by the formula (6).$\text{Vout} \text{8 = -} \frac{\text{C} \text{81} \text{Vin} \text{81 +} \text{C} \text{82} \text{Vin} \text{82 +} \text{C} \text{83} \text{Vin} \text{83}}{\text{C} \text{84}}$ It is defined that the capacity ratio is C81:C82:C83:C84=1:1:2:2. A normalized output of inverted addition value can be obtained as in formula (7).$\text{Vout} \text{8 = -} \frac{\text{Vin} \text{81 +} \text{Vin} \text{82 +} \text{Vin} \text{83}}{\text{2}}$ Here, the weight of C83 is defined twice as large as C81 and C82 so as to cancel the influence of the normalization by ADD25 and to agree to unnormalized V81 and V82. By the normalization, the maximum voltage is limited under the supply voltage.

An output of the last stage inverter I83 is connected to the ground through a grounded capacitance C85. An output of the second stage inverter I82 is connected to the supply voltage Vdd and the ground through a pair of balancing resistances R81 and R82. The unstable oscillation of inverted amplifying circuit including feedback is prevented.

The reference voltage Vr is generated by a reference voltage generating circuit Vrcf in Fig. 9. The reference voltage generating circuit includes three stages serial inverters I91, 192 and I93, and an output of the last stage is fed back to the first stage input. Similarly to the inverted amplifying portions, unstable oscillation is prevented by a grounded capacitance C95 and balancing resistances R91 and R92. The output of the reference voltage circuit converges to a stable point on which an input and output voltages are equal to each other, and any reference voltage can be generated by changing the threshold of each inverter. Generally, in many cases, it is settled that Vr=Vdd/2 in order to keep dynamic range enough large in both directions of plus an minus. Here, Vdd is the supply voltage of MOS inverter.

As shown in Fig. 10, the accumulation circuit SUM includes a capacitive coupling CP10 which includes capacitances C101 and C102 of corresponding number to the number of MF1 and MF2. The output of CP10 is connected to three stages serial MOS inverters I101, I102 and 1103. An output of MOS inverter 1103 of the last stage is connected to an input of I101 through a feedback capacitance C103. An inversion of an output of CP10 is generated at an output of I103 with a good linearity. Assuming input voltages of capacitances C101 and C102 to be Vin101 and Vin102, an output Vout10 of I103 can be expressed by the formula (8).$\text{Vout} \text{10 = -} \frac{\text{C} \text{101} \text{Vin} \text{101 +} \text{C} \text{102} \text{Vin} \text{72}}{\text{C} \text{103}}$ Here, Vin101, Vin102 and Vout10 are voltages referencing the reference voltage Vr. Also, it is defined that the capacitance ratio is C101:C102:C103=1:1:2. Then, a normalized output of an inverted addition is obtained as in formula (9).$\text{Vout} \text{10 = -} \frac{\text{Vin} \text{101 +} \text{Vin} \text{102}}{\text{2}}$ By the normalization, the maximum voltage is limited under the supply voltage.

An output of the last stage inverter I103 is connected to the ground through a grounded capacitance C104. An output of the second stage inverter I102 is connected to the supply voltage Vdd and the ground through a pair of balancing resistances R101 and R102. The unstable oscillation of inverted amplifying circuit including feedback line is prevented.

Concerning to the matched filter circuit above, the size of the circuit is largely reduced compared with a digital one because an addition is performed by an analog system by means of a capacitive coupling, and the processing speed is high because of parallel addition. As the inputs and outputs of the sampling and holding circuit and addition portion are all voltage signals, electric power consumption is low.

The accuracy of an output of an addition portion depends on the dispersion in characteristics of MOS inverters and in capacity ratio of capacitances. The dispersion of inverters can be minimized by placing them closely to one another. The accuracy of the capacity ratio of a capacitance can be improved by dispersively connecting a plurality of unit capacitances

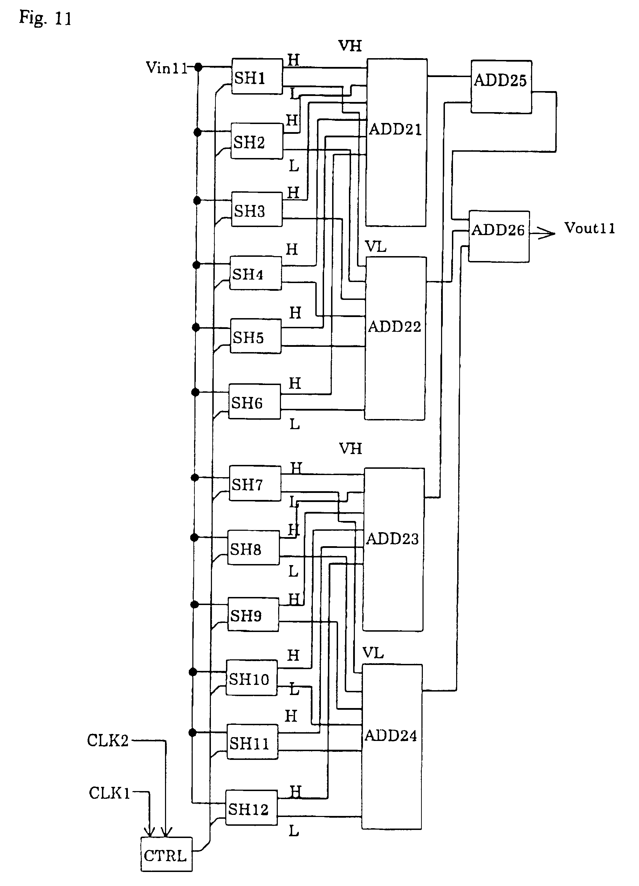

Fig. 11 shows a matched filter circuit structured in one body for double-sampling as the second embodiment.

In the second embodiment, the number of sampling and holding circuits is twice as many as those in Fig. 2, which are parallelly connected to an input voltage Vin11. The sampling and holding circuits are classified into two groups, the first group of SH1 to SH6 and the second group of SH7 to SH12. The first group is driven by the clock CLK1 (not shown), and the second group is driven by the clock CLK2. That is, the first and second groups are driven by shifted timings by Tc/2 from each other. High outputs VH of sampling and holding circuits from SH1 to SH6 are input to an addition portion ADD21 and added, and low outputs VL are input to an addition portion ADD22 and added. Outputs of ADD21 and ADD23 are added by Add25, and outputs of ADD22 and ADD24 are input to ADD26 with an output of ADD25. In adders from ADD21 to ADD24, the number of capacitances of capacitive coupling is increased to 6, more than the number of the circuit in Fig. 6. Therefore, the capacity of a feedback capacitance C64 is settled twice as large as Fig. 6. Adders ADD25 and ADD26 are the same structures as in Fig. 7 and Fig. 8, respectively.

As in the second embodiment, when the structure of one body is adopted, it is effective to realize a circuit in small size and high speed. As in the first embodiment, when two matched filters are parallelly used, it is possible to be flexibly applied to much more sampling.

In a matched filter circuit according to the present invention, a sampling and holding circuit is classified into two groups, the control circuit alternatively closes the switches in the first group by a chip time in sequence, also at the same time, alternatively closes the switches in the second group by a chip time shifted by 1/2 chip time in sequence. Therefore, it is possible to perform double-sampling.

## Claims

1. A matched filter circuit for a spread spectrum communication, comprising:
(I) a plurality of sampling and holding circuits (SH1-SH6) each of which comprises:
i) a switch (SW) connected to an input voltage (Vin);
ii) a first capacitance (C31) connected to an output of said switch (SW);
iii) a first inverted amplifying portion (I1, I2, I3) having an odd number of stages of MOS inverters connected to an output of said first capacitance (C31);
iv) a first feedback capacitance (C32) for connecting the output of said first inverted amplifying portion (I1, I2, I3) to its input; and
v) a first and a second multiplexer (MUX31, MUX32) for alternatively outputting an output of said first inverted amplifying portion (I1, I2, I3) or a reference voltage (Vr);
(II) a first addition portion (ADD21, ADD23) which comprises:
i) a plurality of the second capacitances (C61, C62, C63) corresponding to said sampling and holding circuit (SH1-SH6), to each of which an output of said first multiplexer (MUX31) is connected;
ii) a second inverted amplifying portion (I61, I62, I63) having an odd number of stages of MOS inverters to which outputs of said second capacitances (C61, C62, C63) are commonly connected;
iii) a second feedback capacitance (C64) for connecting an output of said second inverted amplifying portion (I61, I62, I63) to its input;
(III) a second addition portion (ADD22, ADD24) which comprises:
i) a plurality of the third capacitances (C61, C62, C63) corresponding to said sampling and holding circuit (SH1-SH6), to each of which an output of said second multiplexer (MUX32) is connected;
ii) a third inverted amplifying portion (I61, I62, I63) having an odd number of stages of MOS inverters to which outputs of said third capacitance (C61, C62, C63) are commonly connected, and
iii) a third feedback capacitance (C64) for connecting an output of said third inverted amplifying portion (I61, I62, I63) to its input;
(IV) a subtraction portion (ADD25, ADD26) for subtracting an output of said second addition portion (ADD22, ADD24) from an output of said first addition portion (ADD21, ADD23);
(V) a control circuit (CTRL) for closing said switches (SW) in one of said sampling and holding circuits (SH1-SH6) as well as opening other switches (SW) and switching said first and second multiplexer (MUX31, MUX32) of each sampling and holding circuit by a predetermined combination;
**characterized in that**
said sampling and holding circuits (SH1-SH6) are classified into two groups, said control circuit (CTRL) successively closes one of said switches (SW) in said first group (SH1, SH2, SH3) every chip time, at the same time, successively closes one of said switches (SW) in the second group (SH4, SH5, SH6) at a shifted timing by 1/2 chip time from the timing of said first group.

2. The matched filter circuit according to claim 1, wherein each of said groups of sampling and holding circuits (SH1-SH12) comprises:
(I) a third addition portion (ADD21, ADD23) to which an output of said first multiplexer (MUX31) is connected, the outputs of said third addition portion (ADD21, ADD23) of all of said groups being inputted to said subtraction portion (ADD25, ADD26), said third addition portion (ADD21, ADD23) comprising:
(a) a plurality of fourth capacitances (C61, C62, C63) to each of which an output of said first multiplexer (MUX31) of each said sampling and holding circuit (SH1-SH12) is connected;
(b) a fourth inverted amplifying portion (I61, I62, I63) with an odd number of serial MOS inverters, to which outputs of said fourth capacitances (C61, C62, C63) are commonly connected; and
(c) a fourth feedback capacitance (C64) for connecting an output of said fourth inverted amplifying portion (I61-I63) to its input; and
(II) a fourth addition portion (ADD22, ADD24) to which said second multiplexer (MUX32) is connected, outputs of said fourth addition portion (ADD22, ADD24) of all of said groups being inputted to said subtraction portion (ADD25, ADD26), said fourth adding portion (ADD22, ADD24) comprising:
(a) a plurality of fifth capacitances (C61-C63) to each of which an output of said second multiplexer (MUX32) of each said sampling and holding circuit (SH1-SH12) and an output of said second multiplexer (MUX32) are inputted;
(b) a fifth inverted amplifying portion (I61-I63) with an odd number of serial MOS inverters, to which outputs of said fifth capacitances (C61-C63) are commonly connected; and
(c) a fifth feedback capacitance (C64) for connecting an output of said fifth inverted amplifying portion (I61, I62, I63) to its input.

3. A matched filter circuit as claimed in claim 1 or 2, wherein said subtraction portion comprises:
(I) a fifth addition portion (ADD25) to which the outputs of said first addition portion (ADD21, ADD23) or said third addition portion (ADD21, ADD23) are connected, said fifth addition portion (ADD25) comprising:
(a) a plurality of sixth capacitances (C71, C72) to each of which outputs of said first addition portion (ADD21, ADD23) or said third addition portion (ADD21, ADD23) are connected;
(b) a sixth inverted amplifying portion (I71, I72, I73) with an odd number of serial MOS inverters to which outputs of said sixth capacitances (C71, C72) are commonly connected; and
(c) a sixth feedback capacitance (C73) for connecting an output of said sixth inverted amplifying portion (I71, I72, I73) to its input; and
(II) the sixth addition portion (ADD26) to which outputs of said second addition portion (ADD22, ADD24) or said fourth addition portion (ADD22, ADD24) and an output of said fifth addition portion (ADD25) are inputted, said sixth addition portion (ADD26) comprising:
(a) a plurality of seventh capacitances (C81, C82, C83) to each of which outputs of said second addition portion (ADD22, ADD24) or said fourth addition portion (ADD22, ADD24) and an output of said fifth addition portion (ADD25) are connected;
(b) a seventh inverted amplifying portion (I81, I82, I83) having an odd number of serial MOS inverters to which outputs of said seventh capacitances (C81, C82, C83) are commonly connected; and
(c) a seventh feedback capacitance (C84) for connecting an output of said seventh inverted amplifying portion (I81, I82, I83) to its input.

4. The matched filter circuit according to one of claims 1 to 3, wherein said reference voltage (Vr) is generated by a reference voltage generating circuit (Vref) which comprises the eighth inverted amplifying portion (I91-I93) consisting of an odd number of stages of MOS inverter and an output of said eighth inverted amplifying portion (I91-I93) is connected to its input.

5. The matched filter circuit according to one of claims 1 to 4, wherein a grounded capacitance (C33, C65) is connected between an output of said inverted amplifying portion (I1, I2, I3, I61, I62, I63) at the last stage (I3, I63) and the ground, and an output of one of said MOS inverters (I2, I62) is connected to a supply voltage (Vdd) and the ground by a pair of balancing resistances (R31, R32, R61, R62) before said last stage of MOS inverters (I3, I63).

6. The matched filter circuit according to claim 5, wherein said reference voltage (Vr) is set to be 1/2 of the source voltage (Vdd) of said MOS inverter (I1-13, I61-I63).

7. The matched filter circuit according to one of claims 1 to 6, wherein said control circuit (CTRL) controls said all sampling and holding circuits (SH1-SH6) so that the status of said sampling and holding circuits (SH1-SH6) is circulatedly changed.

8. The matched filter circuit according to one of claims 1 to 7, wherein said first multiplexer (MUX31) alternatively outputs said output of said first inverted amplifying portion (I1-I3) or said reference voltage (Vr), and said second multiplexer (MUX32) alternatively outputs said output of said first inverted amplifying portion (I1, I2, I3) or said reference voltage (Vr) inversely to the selection of said first multiplexer (MUX31).

9. The matched filter circuit according to one of claims 1 to 8, wherein one of said first multiplexer (MUX31) and said second multiplexer (MUX32) outputs said output of said first inverted amplifying portion (I1-I3), or both of them output said reference voltages (Vr).

## Patentansprüche

1. Suchfilterschaltung für eine Spreizspektrum-Kommunikation, welche umfaßt:
(I) mehrere Abtast-und-Halte-Schaltungen (SH1-SH6), wovon jede umfaßt:
i) einen Schalter (SW), der mit einer Eingangsspannung (Vin) verbunden ist;
ii) eine erste Kapazität (C31), die mit einem Ausgang des Schalters (SW) verbunden ist;
iii) einen ersten invertierenden Verstärkungsabschnitt (I1, I2, I3) mit einer ungeraden Anzahl von Stufen von MOS-Invertern, die mit einem Ausgang der ersten Kapazität (C31) verbunden sind;
iv) eine erste Rückkopplungskapazität (C32) zum Verbinden des Ausgangs des ersten invertierenden Verstärkungsabschnitts (I1, I2, I3) mit dessen Eingang; und
v) einen ersten und einen zweiten Multiplexer (MUX31, MUX32) zum alternativen Ausgeben eines Ausgangs des ersten invertierenden Verstärkungsabschnitts (I1, I2, I3) oder einer Referenzspannung (Vr);
II) einen ersten Additionsabschnitt (ADD21, ADD23), welcher umfaßt:
i) mehrere zweite Kapazitäten (C61, C62, C63) entsprechend den Abtast-und-Halte-Schaltungen (SH1-SH6), wovon mit jeder ein Ausgang des ersten Multiplexers (MUX31) verbunden ist;
ii) einen zweiten invertierenden Verstärkungsabschnitt (I61, I62, I63) mit einer ungeraden Anzahl von Stufen von MOS-Invertern, mit welchen Ausgänge der zweiten Kapazitäten (C61, C62, C63) gemeinsam verbunden sind;
iii) eine zweite Rückkopplungskapazität (C64) zum Verbinden eines Ausgangs des zweiten invertierenden Verstärkungsabschnitts (I61, I62, I63) mit dessen Eingang;
III) einen zweiten Additionsabschnitt (ADD22, ADD24), welcher umfaßt:
i) mehrere dritte Kapazitäten (C61, C62, C63) entsprechend den Abtast-und-Halte-Schaltungen (SH1-SH6), wovon mit jeder ein Ausgang des zweiten Multiplexers (MUX32) verbunden ist;
ii) einen dritten invertierenden Verstärkungsabschnitt (I61, I62, I63) mit einer ungeraden Anzahl von Stufen von MOS-Invertern, mit welchen Ausgänge der dritten Kapazitäten (C61, C62, C63) verbunden sind;
iii) einer dritten Rückkopplungskapazität (C64) zum Verbinden eines Ausgangs des dritten invertierenden Verstärkungsabschnitts (I61, I62, I63) mit dessen Eingang;
IV) einen Subtraktionsabschnitt (ADD25, ADD26) zum Subtrahieren eines Ausgangs des zweiten Additionsabschnittes (ADD22, ADD24) von einem Ausgang des ersten Additionsabschnittes (ADD22, ADD23);
V) eine Steuerschaltung (CTRL) zum Schließen der Schalter (SW) in einer der Abtast-und-Halte-Schaltungen (SH1-SH6) sowie zum Öffnen anderer Schalter und zum Schalten des ersten und zweiten Multiplexers (MUX31, MUX32) von jeder Abtast-und-Halte-Schaltung mittels einer vorbestimmten Kombination;
**dadurch gekennzeichnet, daß**
die Abtast-und-Halte-Schaltungen (SH1-SH6) in zwei Gruppen klassifiziert sind, die Steuerschaltung (CTRL) sukzessiv einen von den Schaltern (SW) in der ersten Gruppe (SH1, SH2, SH3) an jedem Chipzeitpunkt schließt, gleichzeitig sukzessiv einen von den Schaltern (SW) in der zweiten Gruppe (SH4, SH5, SH6) an einem um eine 1/2 Chipzeit zu dem Chipzeitpunkt der ersten Gruppe verschobenen Zeitpunkt schließt.

2. Suchfilterschaltung nach Anspruch 1, wobei jede von den Gruppen der Abtast-und-Halte-Schaltungen (SH1-SH12) umfaßt:
(I) einen dritten Additionsabschnitt (ADD21, ADD23), mit welchem ein Ausgang des ersten Multiplexers (MUX31) verbunden sind, wobei die Ausgänge des dritten Additionsabschnitts (ADD21, ADD23) von allen diesen Gruppen in den Subtraktionsabschnitt (ADD25, ADD26) eingegeben werden, und der dritte Additionsabschnitt (ADD21, ADD23) umfaßt:
(a) mehrere vierte Kapazitäten (C61, C62, C63 ), wovon mit jeder ein Ausgang des ersten Multiplexers (MUX31) von jeder von den Abtast-und-Halte-Schaltungen (SH1-SH12) verbunden ist;
(b) einen vierten invertierenden Verstärkungsabschnitt (I61,I62,I63) mit einer ungeraden Anzahl von Stufen von MOS-Invertern, mit welchen Ausgänge der vierten Kapazitäten (C61, C62, C63) gemeinsam verbunden sind; und
(c) eine vierte Rückkopplungskapazität (C64) zum Verbinden eines Ausgangs des vierten invertierenden Verstärkungsabschnitts (I61-I63) mit dessen Eingang; und
(II) einen vierten Additionsabschnitt (ADD22, ADD24), mit welchem der zweite Multiplexers (MUX32) verbunden ist, Ausgänge von dem vierten Additionsabschnitt (ADD22, ADD24) von allen von diesen Gruppen in den Subtraktionsabschnitt (ADD25, ADD26) eingegeben werden, und der vierte Additionsabschnitt (ADD22, ADD24) umfaßt:
(a) mehrere fünfte Kapazitäten (C61-C63), wovon in jede ein Ausgang des zweiten Multiplexers (MUX32) von jeder von den Abtast-und-Halte-Schaltungen (SH1-SH12) und ein Ausgang des zweiten Multiplexers (MUX32) eingegeben werden;
(b) einen fünften invertierenden Verstärkungsabschnitt (I61-I63) mit einer ungeraden Anzahl serieller MOS-Inverter, mit welchen Ausgänge der fünften Kapazitäten (C61-C63) gemeinsam verbunden sind; und
(c) eine fünfte Rückkopplungskapazität (C64) zum Verbinden eines Ausgangs des fünften invertierenden Verstärkungsabschnitts (I61, I62, I63) mit dessen Eingang.

3. Suchfilterschaltung nach Anspruch 1 oder 2, wobei der Subtraktionsabschnitt umfaßt:
(I) einen fünften Additionsabschnitt (ADD25), mit welchem die Ausgänge des ersten Additionsabschnitts (ADD21, ADD23) oder des dritten Additionsabschnitts (ADD21, ADD23) verbunden sind, wobei der fünfte Additionsabschnitt (ADD25) umfaßt:
(a) mehrere sechste Kapazitäten (C71, C72 ), wovon mit jeder Ausgänge des ersten Additionsabschnittes (ADD21, ADD23) oder des dritten Additionsabschnittes (ADD21, ADD23) verbunden sind;
(b) einen sechsten invertierenden Verstärkungsabschnitt (I71, I72, I73) mit einer ungeraden Anzahl von Stufen von MOS-Invertern, mit welchen Ausgänge der sechsten Kapazitäten (C71, C72, C73) gemeinsam verbunden sind; und
(c) eine sechste Rückkopplungskapazität (C73) zum Verbinden eines Ausgangs des sechsten invertierenden Verstärkungsabschnitts (I71, I72, I73) mit dessen Eingang; und
(II) einen sechsten Additionsabschnitt (ADD26), mit welchem Ausgänge des zweiten Additionsabschnittes (ADD22, ADD24) oder des vierten Additionsabschnittes (ADD22, ADD24) und ein Ausgang des fünften Additionsabschnittes (ADD 25) eingegeben werden und der sechste Additionsabschnitt (ADD26) umfaßt:
(a) mehrere siebente Kapazitäten (C81, C82, C83), wovon mit jeder Ausgänge des zweiten Additionsabschnittes (ADD22, ADD24) oder des vierten Additionsabschnittes (ADD22, ADD24) und ein Ausgang des fünften Additionsabschnittes (ADD25) verbunden sind;
(b) einen siebenten invertierenden Verstärkungsabschnitt (I81, I82, I83) mit einer ungeraden Anzahl serieller MOS-Inverter, mit welchen Ausgänge der siebenten Kapazitäten (C81, C82, C83) gemeinsam verbunden sind; und
(c) eine siebente Rückkopplungskapazität (C84) zum Verbinden eines Ausgangs des siebenten invertierenden Verstärkungsabschnitts (I81, I82, I83) mit dessen Eingang.

4. Suchfilterschaltung nach Anspruch 1 bis 3, wobei die Referenzspannung (Vr) von einer Referenzspannungs-Erzeugungsschaltung (Vref) erzeugt wird, welche einen achten invertierenden Verstärkungsabschnitt (I91-I93) umfaßt, der aus einer ungeraden Anzahl von Stufen von MOS-Invertern besteht und wovon ein Ausgang des achten invertierenden Verstärkungsabschnitts (I91-I93) mit dessen Eingang verbunden ist.

5. Suchfilterschaltung nach Anspruch 1 bis 4, wobei eine auf Masse liegende Kapazität (C33, C65) zwischen einem Ausgang des invertierenden Verstärkungsabschnittes (I1, I2, I3, I61, I62, I63) bei der letzten Stufe (I3, I63) und Masse angeschlossen ist, und ein Ausgang von einem der MOS-Inverter (I2, I62) mit einer Versorgungsspannung (Vdd) und der Masse über ein Paar von Symmetrierungswiderstände (R31, R32, R61, R62) vor der letzten Stufe der MOS-Inverter (I3, I63 verbunden ist.

6. Suchfilterschaltung nach Anspruch 5, wobei die Referenzspannung (Vr) auf die Hälfte der Versorgungsspannung (Vdd) der MOS-Inverter (11-13, 161-163) eingestellt ist.

7. Suchfilterschaltung nach einem der Ansprüche 1 bis 6, wobei die Steuerschaltung (CTRL) alle Abtast-und-Halte-Schaltungen (SH1-SH6) so steuert, daß der Status der Abtast-und-Halte-Schaltungen (SH1-SH6) zyklisch verändert wird.

8. Suchfilterschaltung nach einem der Ansprüche 1 bis 7, wobei der erste Multiplexer (MUX31) alternativ den Ausgang des ersten invertierenden Verstärkungsabschnittes (I1-I3) oder die Referenzspannung (Vr) ausgibt, und der zweite Multiplexer (MUX32) alternativ den Ausgang des ersten invertierenden Verstärkungsabschnittes (I1, 12, I3) oder die Referenzspannung (Vr) invertiert zu der Auswahl des Multiplexers (MUX31) ausgibt.

9. Suchfilterschaltung nach einem der Ansprüche 1 bis 8, wobei einer von dem ersten Multiplexer (MUX31) oder dem zweiten Multiplexer (MUX32) den Ausgang des ersten invertierenden Verstärkungsabschnittes (I1-I3) ausgibt oder beide die Referenzspannung (Vr) ausgeben.

## Revendications

1. Circuit de filtrage adapté pour une communication à spectre étalé, comprenant :
(I) une pluralité de circuits d'échantillonnage et de maintien (SH1-SH6) comprenant chacun :
i) un commutateur (SW) connecté à une tension d'entrée (Vin),
ii) un premier condensateur (C31) connecté à une sortie dudit commutateur (SW),
iii) une première partie amplificateur inverseur (I1,I2,I3) ayant un nombre impair d'étages d'inverseurs MOS connectés à une sortie dudit premier condensateur (C31),
iv) un premier condensateur de réaction (C32) pour connecter la sortie de ladite première partie amplificateur inverseur (I1,I2,I3) à son entrée, et
v) des premier et deuxième multiplexeurs (MUX31,MUX32) pour sortir alternativement une sortie de ladite première partie amplificateur inverseur (I1,I2,I3) ou une tension de référence (Vr) ;
(II) une première partie d'addition (ADD21,ADD23) qui comprend :
i) une pluralité de deuxièmes condensateurs (C61,C62,C63) correspondant auxdits circuits d'échantillonnage et de maintien (SH1-SH6) à chacun desquels une sortie dudit premier multiplexeur (MUX31) est connectée,
ii) une deuxième partie amplificateur inverseur (I61,I62,I63) ayant un nombre impair d'étages d'inverseurs MOS auxquels les sorties desdits deuxièmes condensateurs (C61,C62,C63) sont connectées en commun, et
iii) un deuxième condensateur de réaction (C64) pour connecter une sortie de ladite deuxième partie amplificateur inverseur (I61,I62,I63) à son entrée ;
(III) une deuxième partie d'addition (ADD22,ADD24) qui comprend :
i) une pluralité de troisièmes condensateurs (C61,C62,C63) correspondant auxdits circuits d'échantillonnage et de maintien (SH1-SH6) à chacun desquels une sortie dudit deuxième multiplexeur (MUX32) est connectée,
ii) une troisième partie amplificateur inverseur (I61,I62,I63) ayant un nombre impair d'étages d'inverseurs MOS auxquels les sorties desdits troisièmes condensateurs (C61,C62,C63)sont connectées en commun, et
iii) un troisième condensateur de réaction (C64) pour connecter une sortie de ladite troisième partie amplificateur inverseur (I61, I62, I63) à son entrée ;
(IV) une partie de soustraction (ADD25,ADD26) pour soustraire une sortie de ladite deuxième partie d'addition (ADD22,ADD24) d'une sortie de ladite première partie d'addition (ADD21,ADD23) ; et
(V) un circuit de commande (CTRL) pour fermer lesdits commutateurs (SW) dans un desdits circuits d'échantillonnage et de maintien (SH1-SH6) ainsi qu'ouvrir les autres commutateurs (SW) et commuter lesdits premier et deuxième multiplexeurs (MUX31,MUX32) de chaque circuit d'échantillonnage et de maintien par une combinaison prédéterminée ;
caractérisé en ce que lesdits circuits d'échantillonnage et de maintien (SH1-SH6) sont classés en deux groupes, ledit circuit de commande (CTRL) ferme successivement un desdits commutateurs (SW) dans ledit premier groupe (SH1,SH2,SH3) à chaque temps d'horloge, et en même temps, ferme successivement un desdits commutateurs (SW) dans le deuxième groupe (SH4,SH5,SH6) à un cadencement décalé d'un demi-temps d'horloge par rapport au cadencement dudit premier groupe.

2. Circuit de filtrage adapté selon la revendication 1, dans lequel chacun desdits groupes de circuits d'échantillonnage et de maintien (SH1-SH12) comprend :
(I) une troisième partie d'addition (ADD21,ADD23) à laquelle une sortie dudit premier multiplexeur (MUX31) est connectée, les sorties de ladite troisième partie d'addition (ADD21,ADD23) de tous lesdits groupes étant entrées dans ladite partie de soustraction (ADD25,ADD26), ladite troisième partie d'addition (ADD21,ADD23) comprenant :
(a) une pluralité de quatrièmes condensateurs (C61,C62,C63) à chacun desquels une sortie dudit premier multiplexeur (MUX31) de chaque dit circuit d'échantillonnage et de maintien (SH1-SH12) est connectée,
(b) une quatrième partie amplificateur inverseur (I61,I62,I63) avec un nombre impair d'inverseurs MOS en série auxquels les sorties desdits quatrièmes condensateurs (C61,C62,C63) sont connectées en commun, et
(c) un quatrième condensateur de réaction (C64) pour connecter une sortie de ladite quatrième partie amplificateur inverseur (I61-I63) à son entrée ; et
(II) une quatrième partie d'addition (ADD22,ADD24) à laquelle ledit deuxième multiplexeur (MUX32) est connecté, les sorties de ladite quatrième partie d'addition (ADD22,ADD24) de tous lesdits groupes étant entrées dans ladite partie de soustraction (ADD25,ADD26), ladite quatrième partie d'addition (ADD22,ADD24) comprenant :
(a) une pluralité de cinquièmes condensateurs (C61-C63) dans chacun desquels une sortie dudit deuxième multiplexeur (MUX32) de chaque dit circuit d'échantillonnage et de maintien (SH1-SH12) et une sortie dudit deuxième multiplexeur (MUX32) sont entrées,
(b) une cinquième partie amplificateur inverseur (I61-I63) avec un nombre impair d'inverseurs MOS en série auxquels les sorties desdits cinquièmes condensateurs (C61-C63) sont connectées en commun, et
(c) un cinquième condensateur de réaction (C64) pour connecter une sortie de ladite cinquième partie amplificateur inverseur (I61,I62,I63) à son entrée.

3. Circuit de filtrage adapté selon la revendication 1 ou 2, dans lequel ladite partie de soustraction comprend :
(I) une cinquième partie d'addition (ADD25) à laquelle les sorties de ladite première partie d'addition (ADD21,ADD23) ou de ladite troisième partie d'addition (ADD21,ADD23) sont connectées, ladite cinquième partie d'addition (ADD25) comprenant :
(a) une pluralité de sixièmes condensateurs (C71,C72) à chacun desquels les sorties de ladite première partie d'addition (ADD21, ADD23) ou de ladite troisième partie d'addition (ADD21,ADD23) sont connectées,
(b) une sixième partie amplificateur inverseur (I71,I72,I73) avec un nombre impair d'inverseurs MOS en série auxquels les sorties desdits sixièmes condensateurs (C71,C72) sont connectées en commun, et
(c) un sixième condensateur de réaction (C73) pour connecter une sortie de ladite sixième partie amplificateur inverseur (I71,I72,I73) à son entrée ; et
(II) la sixième partie d'addition (ADD26) dans laquelle les sorties de ladite deuxième partie d'addition (ADD22,ADD24) ou de ladite quatrième partie d'addition (ADD22,ADD24) et une sortie de ladite cinquième partie d'addition (ADD25) sont entrées, ladite sixième partie d'addition (ADD26) comprenant :
(a) une pluralité de septièmes condensateurs (C81,C82,C83) à chacun desquels les sorties de ladite deuxième partie d'addition (ADD22,ADD24) ou de ladite quatrième partie d'addition (ADD22,ADD24) et une sortie de ladite cinquième partie d'addition (ADD25) sont connectées,
(b) une septième partie amplificateur inverseur (I81, I82, I83) ayant un nombre impair d'inverseurs MOS en série auxquels les sorties desdits septièmes condensateurs (C81,C82,C83) sont connectées en commun, et
(c) un septième condensateur de réaction (C84) pour connecter une sortie de ladite septième partie amplificateur inverseur (I81,I82,I83) à son entrée.

4. Circuit de filtrage adapté selon l'une des revendications 1 à 3, dans lequel ladite tension de référence (Vr) est générée par un circuit générateur de tension de référence (Vref) qui comprend la huitième partie amplificateur inverseur (I91-I93) consistant en un nombre impair d'étages d'inverseurs MOS et une sortie de ladite huitième partie amplificateur inverseur (I91-I93) est connectée à son entrée.

5. Circuit de filtrage adapté selon l'une des revendications 1 à 4, dans lequel un condensateur relié à la masse (C33,C65) est connecté entre une sortie de ladite partie amplificateur inverseur (I1,I2,I3,I61, I62,I63) au dernier étage (I3,I63) et la masse, et une sortie d'un desdits inverseurs MOS (I2,I62) est connectée à une tension d'alimentation (Vdd) et à la masse par une paire de résistances d'équilibrage (R31,R32,R61,R62) avant ledit dernier étage d'inverseurs MOS (I3,I63).

6. Circuit de filtrage adapté selon la revendication 5, dans lequel ladite tension de référence (Vr) est établie afin de valoir la moitié de la tension de source (Vdd) dudit inverseur MOS (I1-I3,I61-I63).

7. Circuit de filtrage adapté selon l'une des revendications 1 à 6, dans lequel ledit circuit de commande (CTRL) commande lesdits circuits d'échantillonnage et de maintien (SH1-SH6) de telle sorte que l'état desdits circuits d'échantillonnage et de maintien (SH1-SH6) est changé de façon circulaire.

8. Circuit de filtrage adapté selon l'une des revendications 1 à 7, dans lequel ledit premier multiplexeur (MUX31) sort alternativement ladite sortie de ladite première partie amplificateur inverseur (I1-I3) ou ladite tension de référence (Vr), et ledit deuxième multiplexeur (MUX32) sort alternativement ladite sortie de ladite première partie amplificateur inverseur (I1,I2,I3) ou ladite tension de référence (Vr) de façon inverse par rapport à la sélection dudit premier multiplexeur (MUX31).

9. Circuit de filtrage adapté selon l'une des revendications 1 à 8, dans lequel l'un dudit premier multiplexeur (MUX31) et dudit deuxième multiplexeur (MUX32) sort ladite sortie de ladite première partie amplificateur inverseur (I1-I3), ou tous les deux sortent ladite tension de référence (Vr).
